# EUROPEAN PATENT SPECIFICATION

(11) **EP 4 376 032 B1**
(45) Date of publication and mention of the grant of the patent: **04.03.2026**
(21) Application number: 21950659.9
(22) Date of filing: 16.08.2021
(51) Int. Cl.: H01F 27/08, H01F 27/16, F03D 80/60, F03D 80/80

(54) **SEMI-OPEN HIGH-POWER DEVICE COOLING SYSTEM AND COOLING METHOD**
HALBOFFENES HOCHLEISTUNGSVORRICHTUNGSKÜHLSYSTEM UND KÜHLVERFAHREN
SYSTÈME DE REFROIDISSEMENT ET PROCÉDÉ DE REFROIDISSEMENT DE DISPOSITIF À HAUTE PUISSANCE SEMI-OUVERT

(30) Priority: 19.07.2021 CN 202110818155
(43) Date of publication of application: 29.05.2024
(73) Proprietor: Envision Energy Technology Pte Ltd., 079903 Singapore (SG)
(72) Inventor: WU, Nubin, Wuxi, Jiangsu 214443 (CN); CHEN, Xiong, Wuxi, Jiangsu 214443 (CN); YANG, Jian, Wuxi, Jiangsu 214443 (CN); XU, Rong, Wuxi, Jiangsu 214443 (CN); YANG, Henghui, Wuxi, Jiangsu 214443 (CN); TAN, Linchuan, Wuxi, Jiangsu 214443 (CN); SU, Baohuan, Wuxi, Jiangsu 214443 (CN); YIN, Lu, Wuxi, Jiangsu 214443 (CN)
(74) Representative: Balder IP Law, S.L.
(86) International application number: PCT/CN2021/112694
(87) International publication number: WO 2023/000417

(56) References cited:
- EP-A1- 2 853 734
- CN-A- 102 165 539
- CN-A- 102 468 038
- CN-A- 103 939 295
- CN-A- 105 179 180
- CN-U- 204 117 767
- CN-U- 204 941 792
- CN-U- 205 779 511
- CN-U- 211 045 215
- JP-A- 2013 164 031
- US-A1- 2012 211 991
- US-B2- 8 416 042

## Description

### FIELD OF TECHNOLOGY

In general, the present disclosure relates to the technical field of cooling systems. Specifically, the present disclosure relates to a system and method for cooling a semi-open high-power device.

### BACKGROUND

A cooling system is an important part for a high-power device arranged in a closed environment. An offshore wind generator set is used as an example. The high-power device in the offshore wind generator may be, for example, a wind generator transformer arranged in a wind generator tower and having heating components which are mainly transformer windings.

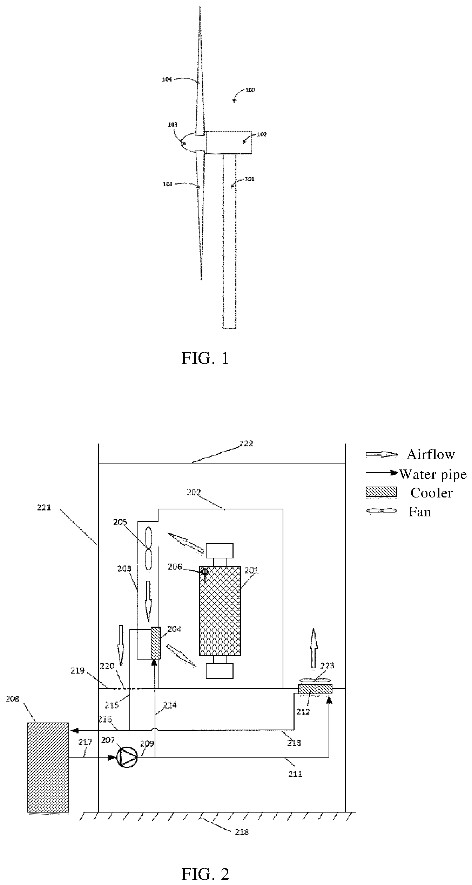

As shown in FIG. 2, the wind generator transformer in the prior art is generally an enclosed water-cooled dry-type transformer, in which transformer windings 201 are cooled through a cooling backpack 203 arranged on the side surface of the wind generator transformer. However, due to the use of the enclosed water-cooled dry-type transformer, air inside the wind generator tower is isolated from air inside the wind generator transformer. Therefore, a tower cooler 212 needs to be separately arranged on the wind generator tower to cool a tower environment. In this way, both the wind generator transformer and the wind generator tower environment need to be configured with independent cooling devices, which leads to high total cost of a cooling system and great increase in self power consumption of the offshore wind generator set. Moreover, the cooling backpack 203 generally needs to be arranged on the side surface of the wind generator transformer, resulting in large circumferential size of the wind generator transformer and inconvenience for the wind generator transformer to be arranged in the wind generator tower. In addition, because ventilation is implemented on only the cooling backpack side, flow uniformity of ventilation is poor, which causes local temperature rise hotspots to be formed on the leeward side of the transformer winding 201.

CN204941792U discloses a semi-open high-power device cooling system and method. The system comprises a semi-open high-power device structure, a semi-open high-power device, inner heat dissipators, inner heat dissipator fans, and a pipeline connection cooling system. According the present invention, the cooling requirements of the semi-open high-power device and a closed environment can be satisfied at the same time, such that the total cost of the cooling system is greatly reduced; according to the present invention, the convective heat transfer of the outer wall of the semi-open high-power device structure can be enhanced by 5-10 kW, thereby significantly reducing self-power-consumption of the cooling system; and according to the present invention, by cancelling a cooling backpack and arranging a plurality of inner heat dissipators below the semi-open high-power device, the pressure of size restriction for a high-power device in a layout of the closed environment is effectively relieved, and localized hot spots of a heat generating element are effectively reduced using double-sided ventilation compared to single-sided ventilation

### SUMMARY

The invention is set out in the appended set of claims, with claim 1 defining a system for cooling a semi-open high-power device and claim 11 defining a method for cooling a semi-open high-power device. To solve at least some of the above problems in the prior art, the present disclosure proposes a system for cooling a semi-open high-power device, including:
a semi-open high-power device structure, including:
   a first platform configured to carry a semi-open high-power device and having ventilation holes; and
   a semi-open high-power device structure outer wall configured to surround the semi-open high-power device and being in contact with an atmospheric environment;
the semi-open high-power device, including:
   one or more heating elements; and
   a semi-open high-power device housing surrounding the one or more heating elements and including:
      a plurality of semi-open high-power device air inlets provided at an upper part of a side wall of the semi-open high-power device housing; and
      semi-open high-power device air outlets provided at a bottom of the semi-open high-power device housing;
inner radiators connected to the semi-open high-power device air outlets, where inner radiator fans are arranged below the wind generator inner radiators;
the inner radiator fans connected to the inner radiators; and
a pipeline connected cooling system connected to the inner radiators.

In an embodiment of the present disclosure, the inner radiators are arranged below the semi-open high-power device, and the inner radiator fans are arranged below the inner radiators.

In an embodiment of the present disclosure, the pipeline connected cooling system includes a pipeline connected air conditioning system or a pipeline connected water cooling system.

In an embodiment of the present disclosure, the pipeline connected water cooling system includes:
a water pump;
water cooling pipelines; and
an outer radiator arranged outside the semi-open high-power device structure and connected to the inner radiators.

In an embodiment of the present disclosure, the ventilation holes include a plurality of grid holes provided in a continuous\spaced manner or grid rings arranged in a surrounding manner.

In an embodiment of the present disclosure, the plurality of semi-open high-power device air inlets are provided in a continuous\spaced manner at the upper part of the side wall of the semi-open high-power device housing.

In an embodiment of the present disclosure, the plurality of semi-open high-power device air outlets are symmetrically provided by using a center of the bottom of the semi-open high-power device housing as a symmetric center or an approximate center;
the plurality of semi-open high-power device air outlets are connected to one of the plurality of inner radiators separately; and
the plurality of inner radiators are connected to one of the plurality of inner radiator fans separately.

In an embodiment of the present disclosure, the plurality of inner radiators are connected in parallel or in series through the water cooling pipelines.

In an embodiment of the present disclosure, temperature sensors are arranged on each of the heating elements.

In an embodiment of the present disclosure, the semi-open high-power device structure further includes one or more second platforms arranged to cover the semi-open high-power device at least above the semi-open high-power device.

In an embodiment of the present disclosure, the semi-open high-power device structure includes a wind generator tower and a container.

In an embodiment of the present disclosure, the semi-open high-power device includes a transformer and a frequency converter.

The present disclosure further proposes a method for cooling a semi-open high-power device using the system for cooling a semi-open high-power device, including the following steps:
cooling a semi-open high-power device through a first cooling cycle, which includes the following steps:
   taking away heat and forming a first hot airflow after a first cold airflow passes through outer surfaces and air gaps of one or more heating elements;
   driving the first hot airflow by inner radiator fans to penetrate through inner radiators, and cooling to form a second cold airflow;
   enabling the second cold airflow to enter a semi-open high-power device structure, and forming a third cold airflow by mixing with upper air in the semi-open high-power device structure through ventilation holes and convectively exchanging heat with a semi-open high-power device structure outer wall; and
   enabling the third cold airflow to flow back into the semi-open high-power device through a plurality of semi-open high-power device air inlets to form the first cooling cycle; and
cooling the semi-open high-power device through a second cooling cycle, where an external cooling system exchanges heat to cool the inner radiators in the second cooling cycle.

In an embodiment of the present disclosure, cooling the semi-open high-power device through a second cooling cycle includes the following steps:
absorbing heat of the first hot airflow by the inner radiators, and forming a first hot water flow;
driving the first hot water flow by a water pump to be conveyed to an outer radiator through water cooling pipelines;
discharging heat of the first hot water flow into an atmospheric heat sink by the outer radiator, and forming a second cold water flow after cooling; and
driving the second cold water flow by the water pump to be conveyed to the inner radiators through the water cooling pipelines to form the second cooling cycle.

The present disclosure further proposes a wind generator, having the system for cooling a semi-open high-power device.

The present disclosure further proposes an energy storage system, having the system for cooling a semi-open high-power device.

The present disclosure has at least the following beneficial effects: the present disclosure adopts the semi-open high-power device, which is combined with an external closed environment to meet cooling requirements, thereby greatly reducing the total cost of the cooling system; the present disclosure may enhance convective heat exchange with the semi-open high-power device structure outer wall by 5-10 kW, thereby significantly reducing self power consumption of the cooling system; the present disclosure effectively relieves pressure of size limitation of the high-power device in the external closed environment by canceling a cooling backpack and arranging the plurality of inner radiators in a symmetry or approximate symmetry manner below the semi-open high-power device, thereby improving the feasibility of the built-in devices such as the high-power transformer and the high-power frequency converter; and bilateral ventilation effectively improves flow uniformity in cooled parts and reduces local hotspots of the heating elements compared with unilateral ventilation.

### BRIEF DESCRIPTION OF THE DRAWINGS

To further illustrate the advantages and features in the embodiments of the present disclosure and others, more specific descriptions of the embodiments of the present disclosure will be presented with reference to the accompanying drawings. It can be understood that these accompanying drawings only depict typical embodiments of the present disclosure, and therefore will not be considered as a limitation to its scope. In the accompanying drawings, for the sake of clarity, the same or corresponding components will be denoted with the same or similar signs.
FIG. 1 shows a schematic diagram of a wind generator to which the present disclosure is applied;
FIG. 2 shows a schematic structural diagram of a system for cooling a semi-open high-power device in the prior art; and
FIG. 3 shows a schematic structural diagram of a system for cooling a semi-open high-power device according to an embodiment of the present disclosure.

### DETAILED DESCRIPTION OF THE EMBODIMENTS

It should be pointed out that the components in the accompanying drawings may be exaggeratedly shown for illustrative purposes and may not necessarily be proportionally correct. In the accompanying drawings, the same or functionally same components are denoted with the same reference numerals.

In the present invention, unless otherwise specified, the terms "arranged on...", "arranged above...", and "arranged over..." do not exclude the existence of an intermediate between the two. In addition, the term "arranged on or above..." only indicates a relative positional relationship between two components, and in a specific situation, for example, after the direction of a product is inverted, it may also be converted into the term "arranged under or below...", and vice versa.

In the present disclosure, the embodiments are only intended to illustrate the solutions of the present disclosure and should not be understood as restrictive.

In the present disclosure, unless otherwise specified, the quantifiers "one" and "a/an" do not exclude a scenario where a plurality of elements exist.

Herein, it should also be pointed out that in the embodiments of the present disclosure, for clarity and simplicity, only some parts or components may be shown, but those of ordinary skill in the art can understand that required parts or components may be added according to requirements of specific scenarios under the guidance of the present disclosure. In addition, unless otherwise specified, the features in different embodiments of the present disclosure may be combined with each other. For example, a feature in the second embodiment may be used to replace a corresponding or functionally same or similar feature in the first embodiment, and the obtained embodiment also falls within the scope of disclosure or description of the present application.

Herein, it should also be pointed out that within the scope of the present disclosure, the terms "same", "equal", "equal to", etc. do not mean that the values of the two are absolutely equal, but rather allow for a specific reasonable error, that is to say, the terms also cover "basically same", "basically equal", and "basically equal to". By analogy, in the present disclosure, the terms "perpendicular to", "parallel to", etc. which indicate the directions also cover the meanings of "basically perpendicular to" and "basically parallel to".

In addition, the numbers of the steps of each method according to the present disclosure do not limit an execution order of the method steps. Unless otherwise specified, the steps of each method may be executed in a different order.

The present disclosure is further described below with reference to the accompanying drawings and specific embodiments.

The present disclosure may be applied to a wind generator or an energy storage system. FIG. 1 shows a schematic diagram of a wind generator 100 to which the present disclosure is applied. As shown in FIG. 1, the wind generator 100 includes a wind generator tower 101 and a nacelle 102 rotatably connected to the wind generator tower 101 and supporting a hub 103. Two or more blades 104 are arranged on the hub 103, where the blades 104 drive a rotor (not shown) arranged in the hub 108 to rotate about an axis (not shown) under the action of wind, and the rotation of the rotor of the power generator relative to a stator will cause electrical energy to be generated.

An embodiment of the present disclosure proposes a system for cooling a semi-open high-power device, including a semi-open high-power device structure, a semi-open high-power device, inner radiators, and a pipeline connected cooling system. The semi-open high-power device structure may surround the semi-open high-power device, and may be, for example, a wind generator tower or a container. Heating elements are provided in the semi-open high-power device. The semi-open high-power device may be, for example, a transformer or a frequency converter. The wind generator transformer in the wind generator tower is used as an example. In the wind generator transformer, the heating elements include transformer windings. The pipeline connected cooling system is connected to the wind generator inner radiators, and may be a water cooling system or an air conditioning system. However, those skilled in the art should understand that the semi-open high-power device structure, the semi-open high-power device, and the pipeline connected cooling system are all not limited to the examples given, and those skilled in the art may make adaptive choices according to actual requirements.

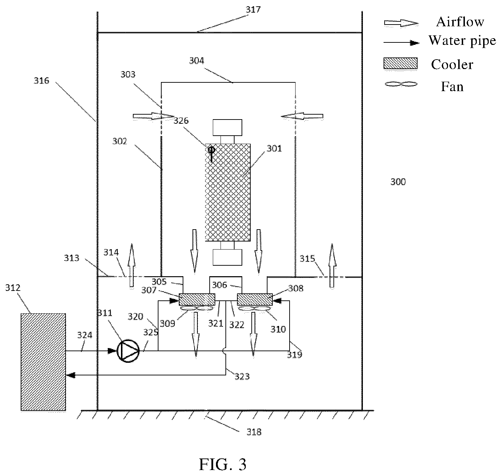

As shown in FIG. 3, a system 300 for cooling a semi-open high-power device in an embodiment of the present disclosure may include a wind generator tower, a wind generator transformer, tower inner radiators, and a tower outer radiator, where the tower inner radiators are connected to the tower outer radiator through water cooling pipelines and a water pump to form an external cooling system.

The wind generator tower may include a first tower platform 313, a second tower platform 317, a tower outer wall 316, and a tower foundation 318.

The first tower platform 313 is arranged below the wind generator transformer to carry the wind generator transformer, and the first tower platform 313 has ventilation holes 314 and 315. The ventilation holes 314 and 315 may be, for example, a plurality of grid holes provided in a continuous\spaced manner or grid rings arranged in a surrounding manner.

The tower outer wall 316 is arranged to surround the wind generator transformer on at least a side surface of the wind generator transformer, and is connected to the tower foundation 318.

There is one or more second tower platforms 317. The one or more second tower platforms 317 are arranged to cover the wind generator transformer at least above the wind generator transformer, and are connected to the tower outer wall 316.

The wind generator transformer includes one or more transformer windings 301 and a transformer case 304.

A plurality of temperature sensors 326 may be arranged on the transformer winding 301. The plurality of temperature sensors 326 may be distributed throughout the transformer winding 301 and may detect temperature changes at different positions of the transformer winding 301.

The transformer case 304 surrounds the transformer windings and includes a plurality of transformer air inlets 303 and transformer air outlets 305 and 306.

The plurality of transformer air inlets 303 may be provided in a continuous\spaced manner on a side wall of the transformer case 304, especially at an upper part of the side wall thereof. Herein, the term "upper part" refers to that a distance from a top surface is less than a distance from a bottom surface, and the term "lower part" refers to that the distance from the bottom surface is less than the distance from the top surface.

The transformer air outlets 305 and 306 are provided at a bottom of the transformer case, and the plurality of transformer air outlets 305 and 306 may be symmetrically provided by using a center of the bottom of the transformer case as a symmetric center or an approximate center, thereby implementing bilateral ventilation of the transformer windings 301. The plurality of transformer air outlets 305 and 306 are provided in a bilateral symmetry manner, which may improve flow uniformity of cooling air on the transformer windings 301, achieve a better cooling effect, and effectively avoid local temperature rise hotspots.

Through the transformer air inlets 303 and the transformer air outlets 305 and 306, internal cooling of the semi-open transformer and cooling of a tower environment may be coupled together, and the tower inner radiators 307 and 308 are used to simultaneously meet heat exchange requirements of the transformer windings 301 and an air environment in a tower.

The tower inner radiators 307 and 308 are arranged below the wind generator transformer, the plurality of transformer air outlets 305 and 306 are connected to one of the plurality of corresponding tower inner radiators 307 and 308 separately, and the plurality of tower inner radiators 307 and 308 are connected to one of the plurality of tower inner radiator fans 309 and 310 separately. The tower inner radiators 307 and 308 are arranged below the bottom of the wind generator transformer, making them more suitable to be placed in the tower with a finite radius compared with a conventional cooling backpack.

The air in the tower may be driven by the tower inner radiator fans 309 and 310 to penetrate through the ventilation holes 314 and 315, and convectively exchanges heat with the tower outer wall 316, thereby effectively reducing self power consumption of the tower outer radiator 312.

The tower outer radiator 312 is arranged outside the wind generator tower and is connected to the tower inner radiators 307 and 308 through the water pump 311 and the water cooling pipelines 319 to 325. The plurality of tower inner radiators 307 and 308 are connected in parallel through the water cooling pipelines. The external cooling system in this embodiment is constructed by connecting the tower outer radiator 312 to the plurality of tower inner radiators 307 and 308 in the above way.

The arrangement of the above cooling system may form a first cooling cycle and a second cooling cycle of the system for cooling a semi-open high-power device.

The first cooling cycle is as follows: power consumption of the transformer windings 301 causes their temperatures to rise, cold air passes through outer surfaces and air gaps of the transformer windings 301 to take away heat, hot air is driven by the tower inner radiator fans 309 and 310 to penetrate through the tower inner radiators 307 and 308 to transfer the heat to the tower inner radiators 307 and 308, and cooled air enters the tower environment and is mixed with upper air of the tower above the first tower platform through the ventilation holes 314 and 315. In this process, the air in the tower may enhance convective heat exchange with the tower outer wall 316. Finally, the cold air flows back into the transformer through the plurality of transformer air inlets 303 above the side wall of the transformer case 304, thereby forming an entire air cooling loop.

The second cooling cycle of water is as follows: the plurality of tower inner radiators 307 and 308 are connected in parallel to the water pump 311, the tower outer radiator 312, and devices with other power through the water cooling pipelines 319 to 325. After the tower inner radiators 307 and 308 cool the hot air, the discharged water temperatures thereof rise. Hot water is driven by the water pump 311 to flow through the tower outer radiator 312 and is discharged into an atmospheric heat sink through active or passive air cooling. Cooled water will continue to be used for circulating heat exchange.

While the embodiments of the present disclosure have been described above, it should be understood that they are presented only as examples and not as a limitation. Apparently, those skilled in the relevant field may make various combinations, modifications, and changes to the embodiments without departing from the scope of the present disclosure. Therefore, the width and scope of the present disclosure disclosed herein should not be limited by the exemplary embodiments disclosed above, and should be defined only according to the appended claims.

## Claims

1. A system for cooling a semi-open high-power device, comprising:
a semi-open high-power device structure, comprising:
a first platform (313) configured to carry a semi-open high-power device and having ventilation holes (314, 315);
a second platform (317) arranged to cover the semi-open high-power device at least above the semi-open high-power device;
a foundation (318) at a bottom of the semi-open high-power device structure; and
a semi-open high-power device structure outer wall (316) configured to surround the semi-open high-power device and being in contact with an atmospheric environment;
wherein the first platform (313), the second platform (317) and the foundation (318) are each connected to the semi-open high-power device structure outer wall (316), wherein the first platform (313), the second platform (317) and the semi-open high-power device structure outer wall (316) defines a first space, and the first platform (313), the foundation (318), and the semi-open high-power device structure outer wall (316) defines a second space;
the semi-open high-power device, comprising:
one or more heating elements (301); and
a semi-open high-power device housing (304), located in the first space, surrounding the one or more heating elements (301) and comprising:
a plurality of semi-open high-power device air inlets (303) provided at an upper part of a side wall of the semi-open high-power device housing (304); and
semi-open high-power device air outlets (305, 306) provided at a bottom of the semi-open high-power device housing (304), wherein the semi-open high-power device housing (304) defines a receiving cavity, the one or more heating elements (301) are completely received in the receiving cavity, and the receiving cavity is communicated with the first space via the plurality of semi-open high-power device air inlets (303), and is communicated with the second space via the semi-open high-power device air outlets (305, 306);
inner radiators (307, 308) arranged below the semi-open high-power device and connected to the semi-open high-power device air outlets (305, 306);
inner radiator fans (309, 310) arranged below the inner radiators (307, 308), connected to the inner radiators (307, 308) and configured to drive air in the receiving cavity to flow into the second space through the semi-open high-power device air outlets (305, 306) and the inner radiators (307, 308), then enter the first space through the ventilation holes (314, 315), and finally get back into to the receiving cavity through the plurality of semi-open high-power device air inlets (303); and
a pipeline connected cooling system connected to the inner radiators (307, 308).

2. The system for cooling a semi-open high-power device according to claim 1, wherein the pipeline connected cooling system comprises a pipeline connected air conditioning system or a pipeline connected water cooling system.

3. The system for cooling a semi-open high-power device according to claim 2, wherein the pipeline connected water cooling system comprises:
a water pump (311);
water cooling pipelines (319, 320, 321, 322, 323, 324, 325); and
an outer radiator arranged outside the semi-open high-power device structure and connected to the inner radiators (307, 308).

4. The system for cooling a semi-open high-power device according to claim 1, wherein the ventilation holes (314, 315) comprise a plurality of grid holes provided in a continuous\spaced manner or grid rings arranged in a surrounding manner.

5. The system for cooling a semi-open high-power device according to claim 1, wherein the plurality of semi-open high-power device air inlets (303) are provided in a continuous\spaced manner at the upper part of the side wall of the semi-open high-power device housing (304).

6. The system for cooling a semi-open high-power device according to claim 3, wherein the plurality of semi-open high-power device air outlets (305, 306) are symmetrically provided by using a center of the bottom of the semi-open high-power device housing (304) as a symmetric center or an approximate center;
the plurality of semi-open high-power device air outlets (305, 306) are connected to one of the plurality of inner radiators (307, 308) separately; and
the plurality of inner radiators (307, 308) are connected to one of the plurality of inner radiator fans (309, 310) separately.

7. The system for cooling a semi-open high-power device according to claim 6, wherein the plurality of inner radiators (307, 308) are connected in parallel or in series through the water cooling pipelines (319, 320, 321, 322, 323, 324, 325).

8. The system for cooling a semi-open high-power device according to claim 1, wherein temperature sensors are arranged on each of the heating elements (301).

9. The system for cooling a semi-open high-power device according to claim 1, wherein the semi-open high-power device structure comprises a wind generator tower and a container.

10. The system for cooling a semi-open high-power device according to claim 1, wherein the semi-open high-power device comprises a transformer and a frequency converter.

11. A method for cooling a semi-open high-power device using the system for cooling a semi-open high-power device according to one of claims 1 to 10, comprising the following steps:
cooling a semi-open high-power device through a first cooling cycle, which comprises the following steps:
taking away heat and forming a first hot airflow after a first cold airflow passes through outer surfaces and air gaps of one or more heating elements (301);
driving the first hot airflow by inner radiator fans (309, 310) to penetrate through inner radiators (307, 308), and cooling to form a second cold airflow;
enabling the second cold airflow to enter a semi-open high-power device structure, and forming a third cold airflow by mixing with upper air in the semi-open high-power device structure through ventilation holes (314, 315) and convectively exchanging heat with a semi-open high-power device structure outer wall; and
enabling the third cold airflow to flow back into the semi-open high-power device through a plurality of semi-open high-power device air inlets (303) to form the first cooling cycle; and
cooling the semi-open high-power device through a second cooling cycle, wherein an external cooling system exchanges heat to cool the inner radiators (307, 308) in the second cooling cycle.

12. The method for cooling a semi-open high-power device according to claim 11, wherein cooling the semi-open high-power device through a second cooling cycle comprises the following steps:
absorbing heat of the first hot airflow by the inner radiators (307, 308), and forming a first hot water flow;
driving the first hot water flow by a water pump (311) to be conveyed to an outer radiator through water cooling pipelines (319, 320, 321, 322, 323, 324, 325);
discharging heat of the first hot water flow into an atmospheric heat sink by the outer radiator, and forming a second cold water flow after cooling; and
driving the second cold water flow by the water pump (311) to be conveyed to the inner radiators (307, 308) through the water cooling pipelines (319, 320, 321, 322, 323, 324, 325) to form the second cooling cycle.

13. A wind generator, having the system for cooling a semi-open high-power device according to one of claims 1 to 10.

14. An energy storage system, having the system for cooling a semi-open high-power device according to one of claims 1 to 10.

## Patentansprüche

1. System zum Kühlen einer halboffenen Hochleistungsvorrichtung, umfassend:
eine Struktur der halboffenen Hochleistungsvorrichtung, umfassend:
eine erste Plattform (313), die dazu ausgestaltet ist, eine halboffene Hochleistungsvorrichtung zu tragen, und Lüftungslöcher (314, 315) aufweist;
eine zweite Plattform (317), die eingerichtet ist, um die halboffene Hochleistungsvorrichtung zumindest über der halboffenen Hochleistungsvorrichtung zu bedecken;
ein Fundament (318) an einem Boden der Struktur der halboffenen Hochleistungsvorrichtung; und
eine Außenwand (316) der Struktur der halboffenen Hochleistungsvorrichtung, die dazu ausgestaltet ist, die halboffene Hochleistungsvorrichtung zu umgeben, und mit einer atmosphärischen Umgebung in Kontakt steht;
wobei die erste Plattform (313), die zweite Plattform (317) und das Fundament (318) jeweils mit der Außenwand (316) der Struktur der halboffenen Hochleistungsvorrichtung verbunden sind, wobei die erste Plattform (313), die zweite Plattform (317) und die Außenwand (316) der Struktur der halboffenen Hochleistungsvorrichtung einen ersten Raum definieren, und die erste Plattform (313), das Fundament (318) und die Außenwand (316) der Struktur der halboffenen Hochleistungsvorrichtung einen zweiten Raum definieren;
die halboffene Hochleistungsvorrichtung, umfassend:
ein oder mehrere Heizelemente (301); und
ein Gehäuse (304) der halboffenen Hochleistungsvorrichtung, das sich in dem ersten Raum befindet, das eine oder die mehreren Heizelemente (301) umgibt und umfasst:
eine Vielzahl von Lufteinlässen (303) der halboffenen Hochleistungsvorrichtung, die an einem oberen Teil einer Seitenwand des Gehäuses (304) der halboffenen Hochleistungsvorrichtung bereitgestellt sind;
Luftauslässe (305, 306) der halboffenen Hochleistungsvorrichtung, die an einem Boden des Gehäuses (304) der halboffenen Hochleistungsvorrichtung bereitgestellt sind, wobei das Gehäuse (304) der halboffenen Hochleistungsvorrichtung einen Aufnahmehohlraum definiert, das eine oder die mehreren Heizelemente (301) vollständig in dem Aufnahmehohlraum aufgenommen sind und der Aufnahmehohlraum über die Vielzahl von Einlässen (303) der halboffenen Hochleistungsvorrichtung mit dem ersten Raum verbunden ist und über die Luftauslässe (305, 306) der halboffenen Hochleistungsvorrichtung mit dem zweiten Raum verbunden ist;
innere Kühlkörper (307, 308), die unter der halboffenen Hochleistungsvorrichtung eingerichtet und mit den Luftauslässen (305, 306) der halboffenen Hochleistungsvorrichtung verbunden sind;
innere Kühlkörperlüfter (309, 310), die unter den inneren Kühlkörpern (307, 308) eingerichtet sind, mit den inneren Kühlkörpern (307, 308) verbunden sind und dazu ausgestaltet sind, Luft in dem Aufnahmehohlraum anzutreiben, um durch die Luftauslässe (305, 306) der halboffenen Hochleistungsvorrichtung und die inneren Kühlkörper (307, 308) in den zweiten Raum zu strömen, dann durch die Lüftungslöcher (314, 315) in den ersten Raum einzutreten und schließlich durch die Vielzahl von Lufteinlässen (303) der halboffenen Hochleistungsvorrichtung zurück in den Aufnahmehohlraum zu gelangen; und
ein mit einer Rohrleitung verbundenes Kühlungssystem, das mit den inneren Kühlkörpern (307, 308) verbunden ist.

2. System zum Kühlen einer halboffenen Hochleistungsvorrichtung nach Anspruch 1, wobei das mit der Rohrleitung verbundene Kühlungssystem ein mit einer Rohrleitung verbundenes Klimatisierungssystem oder ein mit einer Rohrleitung verbundenes Wasserkühlungssystem umfasst.

3. System zum Kühlen einer halboffenen Hochleistungsvorrichtung nach Anspruch 2, wobei das mit der Rohrleitung verbundene Wasserkühlungssystem umfasst:
eine Wasserpumpe (311);
Wasserkühlungsrohrleitungen (319, 320, 321, 322, 323, 324, 325); und
einen äußeren Kühlkörper, der außerhalb der Struktur der halboffenen Hochleistungsvorrichtung eingerichtet und mit den inneren Kühlkörpern (307, 308) verbunden ist.

4. System zum Kühlen einer halboffenen Hochleistungsvorrichtung nach Anspruch 1, wobei die Lüftungslöcher (314, 315) eine Vielzahl von Gitterlöchern, die auf eine ununterbrochene/beabstandete Weise bereitgestellt sind, oder Gitterringen umfassen, die auf eine umgebende Weise eingerichtet sind.

5. System zum Kühlen einer halboffenen Hochleistungsvorrichtung nach Anspruch 1, wobei die Vielzahl von Lufteinlässen (303) der halboffenen Hochleistungsvorrichtung auf eine ununterbrochene/beabstandete Weise am oberen Teil der Seitenwand des Gehäuses (304) der halboffenen Hochleistungsvorrichtung bereitgestellt sind.

6. System zum Kühlen einer halboffenen Hochleistungsvorrichtung nach Anspruch 3, wobei die Vielzahl von Luftauslässen (305, 306) der halboffenen Hochleistungsvorrichtung symmetrisch durch Verwenden einer Mitte des Bodens des Gehäuses (304) der halboffenen Hochleistungsvorrichtung als eine symmetrische Mitte oder eine annähernde Mitte bereitgestellt sind;
die Vielzahl von Luftauslässen (305, 306) der halboffenen Hochleistungsvorrichtung separat mit einem der Vielzahl von inneren Kühlkörpern (307, 308) verbunden sind; und
die Vielzahl von inneren Kühlkörpern (307, 308) separat mit einem der Vielzahl von inneren Kühlkörperlüftern (309, 310) verbunden sind.

7. System zum Kühlen einer halboffenen Hochleistungsvorrichtung nach Anspruch 6, wobei die Vielzahl von inneren Kühlkörpern (307, 308) durch die Wasserkühlungsrohrleitungen (319, 320, 321, 322, 323, 324, 325) parallel oder in Reihe verbunden sind.

8. System zum Kühlen einer halboffenen Hochleistungsvorrichtung nach Anspruch 1, wobei die Temperatursensoren auf jedem der Heizelemente (301) eingerichtet sind.

9. System zum Kühlen einer halboffenen Hochleistungsvorrichtung nach Anspruch 1, wobei die Struktur der halboffenen Hochleistungsvorrichtung einen Windkraftanlagenturm und einen Behälter umfasst.

10. System zum Kühlen einer halboffenen Hochleistungsvorrichtung nach Anspruch 1, wobei die halboffene Hochleistungsvorrichtung einen Transformator und einen Frequenzwandler umfasst.

11. Verfahren zum Kühlen einer halboffenen Hochleistungsvorrichtung unter Verwendung des Systems zum Kühlen einer halboffenen Hochleistungsvorrichtung nach einem der Ansprüche 1 bis 10, umfassend die folgenden Schritte:
Kühlen einer halboffenen Hochleistungsvorrichtung durch einen ersten Kühlungszyklus, der die folgenden Schritte umfasst:
Abführen von Wärme und Bilden einer ersten heißen Luftströmung, nachdem eine erste kalte Luftströmung die äußeren Oberflächen und Luftspalte von einem oder mehreren Heizelementen (301) durchquert hat;
Antreiben der ersten heißen Luftströmung durch innere Kühlkörperlüfter (309, 310) zum Eindringen durch die inneren Kühlkörper (307, 308) und Kühlen, um eine zweite kalte Luftströmung zu bilden;
Ermöglichen des Eintretens der zweiten kalten Luftströmung in eine Struktur einer halboffenen Hochleistungsvorrichtung und Bilden einer dritten kalten Luftströmung durch Mischen mit oberer Luft in der Struktur der halboffenen Hochleistungsvorrichtung durch Lüftungslöcher (314, 315) und konvektives Austauschen von Wärme mit einer Außenwand der Struktur der halboffenen Hochleistungsvorrichtung; und
Ermöglichen des Rückströmens der dritten kalten Luftströmung in die halboffene Hochleistungsvorrichtung durch eine Vielzahl von Lufteinlässen (303) der halboffenen Hochleistungsvorrichtung, um den ersten Kühlungszyklus zu bilden; und
Kühlen der halboffenen Hochleistungsvorrichtung durch einen zweiten Kühlungszyklus, wobei ein externes Kühlungssystem Wärme austauscht, um die inneren Kühlkörper (307, 308) in dem zweiten Kühlungszyklus zu kühlen.

12. Verfahren zum Kühlen einer halboffenen Hochleistungsvorrichtung nach Anspruch 11, wobei das Kühlen der halboffenen Hochleistungsvorrichtung durch einen zweiten Kühlungszyklus die folgenden Schritte umfasst:
Absorbieren von Wärme von der ersten heißen Luftströmung durch die inneren Kühlkörper (307, 308) und Bilden einer ersten heißen Wasserströmung;
Antreiben der ersten heißen Wasserströmung mit einer Wasserpumpe (311), um durch Wasserkühlungsrohrleitungen (319, 320, 321, 322, 323, 324, 325) zu einem äußeren Kühlkörper befördert zu werden;
Ableiten von Wärme von der ersten heißen Wasserströmung durch den äußeren Kühlkörper in eine atmosphärische Wärmesenke und Bilden einer zweiten kalten Wasserströmung nach dem Kühlen; und
Antreiben der zweiten kalten Wasserströmung durch die Wasserpumpe (311), um durch die Wasserkühlungsrohrleitungen (319, 320, 321, 322, 323, 324, 325) zu den inneren Kühlkörpern (307, 308) befördert zu werden, um den zweiten Kühlungszyklus zu bilden.

13. Windkraftanlage, die das System zum Kühlen einer halboffenen Hochleistungsvorrichtung nach einem der Ansprüche 1 bis 10 aufweist.

14. Energiespeichersystem, welches das System zum Kühlen einer halboffenen Hochleistungsvorrichtung nach einem der Ansprüche 1 bis 10 aufweist.

## Revendications

1. Système pour refroidir un dispositif à haute puissance semi-ouvert comprenant :
une structure de dispositif à haute puissance semi-ouvert comprenant :
une première plateforme (313) configurée pour porter un dispositif à haute puissance semi-ouvert et ayant des trous de ventilation (314, 315) ;
une seconde plateforme (317) agencée pour recouvrir le dispositif à haute-puissance semi-ouvert au moins au-dessus du dispositif à haute-puissance semi-ouvert ;
une fondation (318) en bas de la structure de dispositif à haute-puissance semi-ouvert ; et
une paroi externe (316) de structure de dispositif à haute-puissance semi-ouvert configurée pour entourer le dispositif à haute-puissance semi-ouvert et étant en contact avec un environnement atmosphérique ;
dans lequel la première plateforme (313), la seconde plateforme (317) et la fondation (318) sont chacune raccordées à la paroi externe (316) de structure de dispositif à haute-puissance semi-ouvert, dans lequel la première plateforme (313), la seconde plateforme (317) et la paroi externe (316) de structure de dispositif à haute-puissance semi-ouvert définissent un premier espace, et la première plateforme (313), la fondation (318) et la paroi externe (316) de structure de dispositif à haute-puissance semi-ouvert définissent un second espace ;
le dispositif à haute-puissance semi-ouvert comprenant :
un ou plusieurs éléments chauffants (301) ; et
un boîtier (304) de dispositif à haute-puissance semi-ouvert situé dans le premier espace, entourant les un ou plusieurs éléments chauffants (301) et comprenant :
une pluralité d'entrées d'air (303) de dispositif à haute-puissance semi-ouvert prévues au niveau d'une partie supérieure d'une paroi latérale du boîtier (304) de dispositif à haute-puissance semi-ouvert ; et
des sorties d'air (305, 306) de dispositif à haute-puissance semi-ouvert prévues en bas du boîtier (304) de dispositif à haute-puissance semi-ouvert, dans lequel le boîtier (304) de dispositif à haute-puissance semi-ouvert définit une cavité de réception, les un ou plusieurs éléments chauffants (301) sont complètement reçus dans la cavité de réception, et la cavité de réception est en communication avec le premier espace via la pluralité d'entrées d'air (303) de dispositif à haute-puissance semi-ouvert, et est en communication avec le second espace via les sorties d'air (305, 306) de dispositif à haute-puissance semi-ouvert ;
des radiateurs internes (307, 308) agencés au-dessous du dispositif à haute-puissance semi-ouvert et raccordés aux sorties d'air (305, 306) de dispositif à haute-puissance semi-ouvert ;
des ventilateurs de radiateur interne (309, 310) agencés sous les radiateurs internes (307, 308), raccordés aux radiateurs internes (307, 308) et configurés pour entraîner l'air dans la cavité de réception à s'écouler dans le second espace par les sorties d'air (305, 306) de dispositif à haute-puissance semi-ouvert et les radiateurs internes (307, 308), entrer ensuite dans le premier espace par les trous de ventilation (314, 315) et revenir finalement dans la cavité de réception par la pluralité d'entrées d'air (303) de dispositif à haute-puissance semi-ouvert ; et
un système de refroidissement raccordé par conduite raccordé aux radiateurs internes (307, 308).

2. Système pour refroidir un dispositif à haute-puissance semi-ouvert selon la revendication 1, dans lequel le système de refroidissement raccordé par conduite comprend un système de climatisation raccordé par conduite ou un système de refroidissement d'eau raccordé par conduite.

3. Système pour refroidir un dispositif à haute-puissance semi-ouvert selon la revendication 2, dans lequel le système de refroidissement d'eau raccordé par conduite comprend :
une pompe à eau (311) ;
des conduites de refroidissement d'eau (319, 320, 321, 322, 323, 324, 325) ; et
un radiateur externe agencé à l'extérieur de la structure de dispositif à haute-puissance semi-ouvert et raccordé aux radiateurs internes (307, 308).

4. Système pour refroidir un dispositif à haute-puissance semi-ouvert selon la revendication 1, dans lequel les trous de ventilation (314, 315) comprennent une pluralité de trous de grille prévus d'une manière continue/espacée ou des anneaux de grille agencés d'une manière périphérique.

5. Système pour refroidir un dispositif à haute-puissance semi-ouvert selon la revendication 1, dans lequel la pluralité d'entrées d'air (303) de dispositif à haute-puissance semi-ouvert sont prévus d'une manière continue/espacée au niveau de la partie supérieure de la paroi latérale du boîtier (304) de dispositif à haute-puissance semi-ouvert.

6. Système pour refroidir un dispositif à haute-puissance semi-ouvert selon la revendication 3, dans lequel la pluralité de sorties d'air (305, 306) de dispositif à haute-puissance semi-ouvert sont prévues, de manière symétrique, en utilisant un centre du bas du boîtier (304) de dispositif à haute-puissance semi-ouvert en tant que centre symétrique ou centre approximatif ;
la pluralité de sorties d'air (305, 306) de dispositif à haute-puissance semi-ouvert sont raccordées à l'un de la pluralité de radiateurs internes (307, 308) séparément ; et
la pluralité de radiateurs internes (307, 308) sont raccordés à l'un de la pluralité de ventilateurs de radiateur interne (309, 310) séparément.

7. Système pour refroidir un dispositif à haute-puissance semi-ouvert selon la revendication 6, dans lequel la pluralité de radiateurs internes (307, 308) sont raccordés en parallèle ou en série par le biais des conduites de refroidissement d'eau (319, 320, 321, 322, 323, 324, 325).

8. Système pour refroidir un dispositif à haute-puissance semi-ouvert selon la revendication 1, dans lequel des capteurs de température sont agencés sur chacun des éléments chauffants (301).

9. Système pour refroidir un dispositif à haute-puissance semi-ouvert selon la revendication 1, dans lequel la structure de dispositif à haute-puissance semi-ouvert comprend une tour d'éolienne et un conteneur.

10. Système pour refroidir un dispositif à haute-puissance semi-ouvert selon la revendication 1, dans lequel le dispositif à haute-puissance semi-ouvert comprend un transformateur et un convertisseur de fréquence.

11. Procédé pour refroidir un dispositif à haute-puissance semi-ouvert utilisant le système pour refroidir un dispositif à haute-puissance semi-ouvert selon l'une des revendications 1 à 10, comprenant les étapes suivantes consistant à :
refroidir un dispositif à haute-puissance semi-ouvert par le biais d'un premier cycle de refroidissement, qui comprend les étapes suivantes consistant à :
retirer la chaleur et former un premier écoulement d'air chaud après qu'un premier écoulement d'air froid est passé par les surfaces externes et les entrefers d'un ou de plusieurs éléments chauffants (301) ;
entraîner le premier écoulement d'air chaud par des ventilateurs de radiateur interne (309, 310) pour pénétrer dans les radiateurs internes (307, 308) et refroidir pour former un deuxième écoulement d'air froid ;
permettre au deuxième écoulement d'air froid d'entrer dans une structure de dispositif à haute-puissance semi-ouvert et former un troisième écoulement d'air froid en se mélangeant avec l'air supérieur dans la structure de dispositif à haute-puissance semi-ouvert par des trous de ventilation (314, 315) et échanger, par convection, la chaleur avec une paroi externe de structure de dispositif à haute-puissance semi-ouvert ; et
permettre au troisième écoulement d'air froid de revenir dans le dispositif à haute-puissance semi-ouvert par une pluralité d'entrées d'air (303) de dispositif à haute-puissance semi-ouvert pour former le premier cycle de refroidissement ; et
refroidir le dispositif à haute-puissance semi-ouvert par un second cycle de refroidissement, dans lequel un système de refroidissement externe échange la chaleur pour refroidir les radiateurs internes (307, 308) dans le second cycle de refroidissement.

12. Procédé pour refroidir un dispositif à haute-puissance semi-ouvert selon la revendication 11, dans lequel l'étape consistant à refroidir le dispositif à haute-puissance semi-ouvert par le biais d'un second cycle de refroidissement comprend les étapes suivantes consistant à :
absorber la chaleur du premier écoulement d'air chaud par les radiateurs internes (307, 308) et former un premier écoulement d'eau chaude ;
entraîner le premier écoulement d'eau chaude par une pompe à eau (311) pour être transporté vers un radiateur externe par le biais des conduites de refroidissement d'eau (319, 320, 321, 322, 323, 324, 325) ;
décharger la chaleur du premier écoulement d'eau chaude dans un dissipateur de chaleur atmosphérique par le radiateur externe et former un second écoulement d'eau froide après refroidissement ; et
entraîner le second écoulement d'eau froide par la pompe à eau (311) pour être transporté vers les radiateurs internes (307, 308) par le biais des conduites de refroidissement d'eau (319, 320, 321, 322, 323, 324, 325) afin de former le second cycle de refroidissement.

13. Éolienne ayant le système pour refroidir un dispositif à haute-puissance semi-ouvert selon l'une des revendications 1 à 10.

14. Système de stockage d'énergie ayant le système pour refroidir un dispositif à haute-puissance semi-ouvert selon l'une des revendications 1 à 10.
